## Europäisches Patentamt

## European Patent Office

## Office européen des brevets

(19)

(11) Veröffentlichungsnummer: **0 010 109**
**A1**

(12) **EUROPÄISCHE PATENTANMELDUNG**

(21) Anmeldenummer: **78101221.6**

(22) Anmeldetag: **25.10.78**

(51) Int. Cl.³: **H 04 B 17/00**
**H 03 J 3/14, H 04 B 1/16**

(43) Veröffentlichungstag der Anmeldung:
**30.04.80 Patentblatt 80/9**

(84) Benannte Vertragsstaaten:
**BE CH FR GB NL SE**

(71) Anmelder: **Bossert, Theodor Tobias, Dipl.-Phys.**
**Wiedenmayerstrasse 2**
**D-8000 München 22(DE)**

(72) Erfinder: **Bossert, Theodor Tobias, Dipl.-Phys.**
**Wiedenmayerstrasse 2**
**D-8000 München 22(DE)**

(74) Vertreter: **Konle, Tilmar, Dipl.-Ing.**
**Institut für Rundfunktechnik GmbH Floriansmühlstrasse**
**60**
**D-8000 München 45(DE)**

(54) **Verfahren und Einrichtung zum Messen der Empfangsqualität eines frequenzmodulierten UKW-Signals.**

(57) Es wird eine einfache Möglichkeit vorgeschlagen, die Qualität des UKW-Stereophonieempfangs im Oszillogramm zu beurteilen. Die Amplitude des UKW-Signalträgers wird auf einen konstanten Wert geregelt und gleichzeitig die auf dem UKW-Signalträger aufmodulierte Störamplitude unbeeinflußt gelassen. Damit wird während des gesamten Meßvorgangs die von der Trägeramplitude gebildete Bezugsachse im Oszillogram festgehalten.

EP 0 010 109 A1

DIPL.-PHYS. TH. BOSSERT
WIEDENMAYERSTRABE 2
8000 MÜNCHEN 22

## VERFAHREN UND EINRICHTUNG ZUM MESSEN DER EMPFANGS- QUALITÄT EINES FREQUENZMODULIERTEN UKW-SIGNALS

Die Erfindung bezieht sich auf ein Verfahren der im Oberbegriff des Anspruchs 1 näher bezeichneten Art sowie auf eine Einrichtung zur Durchführung des Verfahrens. Verfahren und Einrichtungen dieser Art sind bekannt (Forschungsbericht der British Broadcasting Corporation BBC RD 1975/33).

Bei dem Empfang von frequenzmodulierten Ultrakurzwellen (UKW-FM-Empfang) treten infolge der Mehrwegeausbreitung der Ultrakurzwellen Amplituden- und Phasenstörmodulationen auf, welche die Empfangsqualität beeinträchtigen. Für die Beurteilung der Empfangsqualität ist daher die meßtechnische Erfassung der genannten Störmodulationen unerläßlich. Hierbei kann NF-seitig die Phasenstörmodulation nicht erfaßt werden, da während einer UKW-Sendung nicht feststellbar ist, welche Phasenänderungen dem Nutzsignal und welche Phasenänderungen dem Störsignal zuzuordnen sind. Demgegenüber stellt die Amplitudenstörmodulation einen meßtechnisch verwertbaren Störeffekt dar, da UKW-Sender stets mit gleichbleibender Amplitude abstrahlen (sogenannte "Vollaussteuerung"), so daß Amplitudenschwankungen nur durch Störungen verursacht werden können.

Bei einem bekannten Verfahren zur Messung der Amplituden-Störmodulation (Forschungsbericht der British Broadcasting Corporation BBC RD 1975/33 mit dem Titel "A field strength measuring receiver for band II") wird der Amplitudenverlauf des empfangenen UKW-Signals in Abhängigkeit von der Signalfrequenz auf einem Oszillographenschirm wiedergegeben und anhand eines Skalenkreuzes abgelesen. Hierbei muß die Verstärkung des Amplitudensignals, welche die Ordinatenlage der Oszillogrammkurve bestimmt, so gewählt werden, daß die Bezugsachse der Kurve deckungsgleich mit der Abszisse des Skalenkreuzes ist. Die Bezugsachse der Kurve ist eine gedachte horizontale Linie, welche der Kurve bei nicht vorhandenen Reflexionen entspricht. In der Praxis ist jedoch die Wahl der Verstärkung des Amplitudensignals äußerst schwierig und zeitraubend, obwohl das bekannte Verfahren eine automatische Mittelwertregelung für die Verstärkung des Amplitudensignals vorsieht, die in einem geeigneten Augenblick durch Knopfdruck ausgeschaltet wird, wodurch die momentan vorhandene Verstärkung festgehalten wird. Da sich jedoch bei automatischer Mittelwertregelung die Verstärkung auch nach beliebig langer Einstelldauer infolge der fortlaufenden Änderung der Amplitudenstörmodulation und damit der mittleren Amplitude ebenso fortlaufend ändert, liegt die durch Knopfdruck festgehaltene Verstärkung auf einem zufälligen Wert innerhalb des Regelbereichs und liefert daher im allgemeinen nicht die gewünschte Deckungsgleichheit der Bezugsachse mit der Skalenabszisse. Diese fehlende Deckungsgleichheit macht nicht nur die Skalenablesung äußerst schwierig, sondern führt auch dazu, daß der auf 100 % Modulationsgrad bezogene Maßstab der Ordinatenskala verändert wird, so daß die Bedienungsperson in Abhängigkeit von der jeweiligen Lage der gedachten Kurvenbezugsachse den Skalenmaßstab umrechnen muß. Hinzu kommt, daß nach erfolgtem Festhalten der Amplitudensignalverstärkung die Empfangsverhältnisse, insbesondere die Ausrichtung der Empfangsantenne, nicht mehr geändert werden dürfen, wodurch sich das bekannte Verfahren zur Ermittlung optimaler Empfangsverhältnisse, wie dies beispielsweise durch Drehen der Empfangsantenne und gleichzeitiger Messung der Empfangsqualität erfolgen kann, nicht eignet.

Die Aufgabe der Erfindung besteht darin, ein Verfahren und eine Einrichtung der eingangs erwähnten Art dahingehend zu verbessern, daß die Bezugsachse der Oszillogrammkurve für den Verlauf der Störmodulationsamplitude in Abhängigkeit von der Signalfrequenz stets deckungsgleich mit der Skalenabszisse ist und daher mühelos bewertet werden kann, und zwar auch bei Änderung der Empfangsverhältnisse.

Die auf die Schaffung eines Verfahrens gerichtete Teilaufgabe wird erfindungsgemäß durch die im Kennzeichen des Anspruchs 1 angegebenen Merkmale gelöst.

Eine vorteilhafte Ausgestaltung des Verfahrens nach Anspruch 1 ist in dem Anspruch 2 gekennzeichnet.

Die auf die Schaffung einer Einrichtung gerichtete Teilaufgabe wird erfindungsgemäß durch die im Kennzeichen des Anspruchs 3 angegebenen Merkmale gelöst.

Vorteilhafte Ausgestaltungen und Weiterbildungen der Einrichtung nach Anspruch 3 sind in der Ansprüchen 4 bis 6 gekennzeichnet. Mit Hilfe der Maßnahmen gemäß Anspruch 6 werden die für jede Reflexion eigenen, günstigsten Demodulatorbandbreiten eingestellt, wodurch man die optimale Eindeutigkeit der Oszillogrammkurve erhält.

Der Grundgedanke der vorliegenden Erfindung besteht darin, eine automatische Verstärkungsregelung vorzusehen, welche nur die Amplitude des UKW-Trägers auf einen konstanten Wert regelt, dagegen die Amplitudenstörmodulation unbeeinflußt läßt. Hierdurch wird während des gesamten Meßvorganges die zur Bezugsachse der Amplitudenstörmodulation in festem Verhältnis stehende Trägeramplitude auf einen mit der Skalenabszisse zusammenfallenden Konstantwert eingeregelt, wodurch sich die Bezugsachse der
Oszillogrammkurve nicht mehr in Ordinatenrichtung verschiebt bzw.
"auswandert". Die von der Regelung unbeeinflußte Amplitudenstörmodulation ändert sich entsprechend dem tatsächlichen Frequenzverlauf bezüglich der Skalenabszisse und kann daher bequem bei
gleichbleibenden, normierten Verhältnissen bzw. unverändertem
Skalenmaßstab ausgemessen werden. Infolge der Trägeramplitudenregelung während des gesamten Meßvorgangs bleiben Empfangsänderungen, wie sie beispielsweise durch Drehen der Empfangsantenne
hervorgerufen werden, ohne Einfluß auf die mit der Skalenabszisse zusammenfallende Lage der Bezugsachse der Oszillogrammkurve, wodurch gleichzeitig mit der Änderung der Empfangsverhältnisse gemessen und das Empfangsoptimum ermittelt werden
kann.

Die Erfindung wird anhand der Zeichnungen näher erläutert.
Es zeigt:

Fig. 1  ein Blockschaltbild einer erfindungsgemäßen Einrichtung, und

Fig. 2  eine Ansicht einer auf dem Oszillographenschirm der
        Einrichtung nach Fig. 1 wiedergegebenen Kurve, welche
        den Amplitudenverlauf eines störmodulierten
        UKW-Signals in Abhängigkeit von der UKW-Signalfrequenz
        darstellt.

0010109

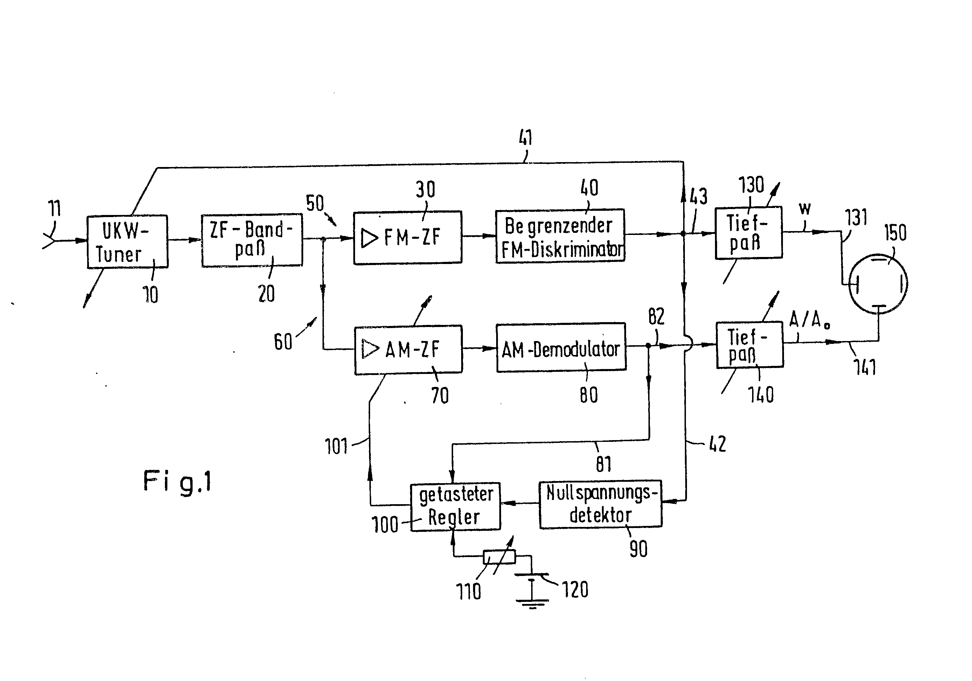

Das in Fig. 1 anhand eines Blockschaltbildes veranschaulichte
Ausführungsbeispiel einer erfindungsgemäßen Meßeinrichtung besteht zu einem Großteil aus einem bekannten UKW-Empfänger, der
für die erfindungsgemäßen Zwecke ergänzt wurde. Im einzelnen
weist die dargestellte Einrichtung einen UKW-Tuner 10 auf,
welcher von einer Antenne 11 mit einem frequenzmodulierten
UKW-Signal gespeist wird. Dem UKW-Tuner 10 ist in üblicher
Weise ein ZF-Bandpaß 20 nachgeschaltet, welcher das in dem
Tuner 10 auf eine Zwischenfrequenz umgesetzte UKW-Signal durchläßt. Der Ausgang des Bandpasses 20 gabelt sich in zwei Signalzweige 50 und 60. Der Signalzweig 50 enthält einen FM-Zwischenfrequenzverstärker 30, dem ein begrenzender FM-Diskriminator 40
nachgeschaltet ist. Der Signalzweig 60 enthält einen AM-Zwischenfrequenzverstärker 70, dem ein AM-Demodulator 80 nachgeschaltet
ist. Der Verstärker 70 ist regelbar, wofür ein Regler 100 vorgesehen ist, dessen Ausgang über eine Leitung 101 mit dem
Steuereingang des Verstärkers 70, dessen Istwert-Eingang über
eine Leitung 81 mit dem Ausgang des Demodulators 80 und dessen
Sollwerteingang mit einem aus einer Gleichspannungsquelle 120
und einem seriengeschalteten Potentiometer 110 bestehenden
Sollwertsteller verbunden ist. Der Regler 100 wird von einem
Nullspannungsdetektor 90, z.B. einem Fensterdiskriminator,
getastet, dessen Eingang über eine Leitung 42 mit dem Ausgang
des Diskriminators 40 verbunden ist. Des weiteren wird das
Ausgangssignal des Diskriminators 40 über eine Leitung 41 auf
den Regeleingang des UKW-Tuners 10 rückgekoppelt. Der Diskriminator 40 und der Demodulator 80 führen über Leitungen 43 bzw. 82 zu jeweils einem bandbreitenvariablen Tiefpaß 130 bzw. 140, an deren Ausgänge ein dem momentanen Frequenzhub $\omega$ bzw. ein der normierten (d.h. auf die Bezugsachse bezogenen) UKW-Signal-amplitude $\frac{A}{A_0}$ entsprechendes Signal anliegt. Der Tiefpaß 130 ist über eine Leitung 131 mit der Horizontalablenkeinrichtung eines Kathodenstrahloszillographen 150 verbunden, dessen Vertikalablenkeinrichtung über eine Leitung 141 von dem Ausgang des Tiefpasses 140 gespeist wird.

Die Funktionsweise der Schaltungsteile 10, 20, 30 und 40 ist aus üblichen UKW-Empfängern bekannt und bedarf keiner näheren Erläuterung. Das in den Signalzweig 60 von dem Bandpaß 20 eingespeiste ZF-Signal wird von dem Verstärker 70 in Abhängigkeit des Regler-Ausgangssignals auf der Leitung 101 derart verstärkt, daß nur die Amplitude des ZF-Trägers einen konstanten Wert besitzt, dagegen die normierte Amplitude $\frac{A}{A_0}$ des AM-Störsignals unbeeinflußt bleibt. Diese getastete Regelung wird durch den Nullspannungsdetektor 90 ermöglicht, welcher feststellt, wann das dem momentanen Frequenzhub $\omega$ proportionale Ausgangssignal des Diskriminators 40 zu Null wird. Ein Frequenzhub $\omega = 0$ bedeutet, daß momentan am Ausgang des Bandpasses 20 der reine ZF-Träger anliegt. In Abhängigkeit von der genannten Feststellung durch den Detektor 90 wird der Regler 100 eingetastet bzw. initiiert, so daß die zum Eintastzeitpunkt an seinem Istwerteingang anliegende Signalamplitude voraussetzungsgemäß

gleich der nichtmodulierten Amplitude des ZF-Trägers ist. Dieser
Istwert wird in üblicher Weise mit dem am Potentiometer 110
eingestellten Sollwert verglichen, wobei das hieraus resultierende
Fehlersignal von dem Regler 100 entsprechend seiner Regelkennlinie in ein Stellsignal für den Verstärker 70 umgesetzt wird.
Sobald der Detektor 90 eine von Null verschiedene Spannung am
Ausgang des Diskriminators 40 feststellt, tastet er den
Regler 100 aus, wodurch bis zur nächstfolgenden Eintastung des
Reglers 100 die im Austastzeitpunkt vorhandene Verstärkungseinstellung des Verstärkers 70 unverändert bleibt.

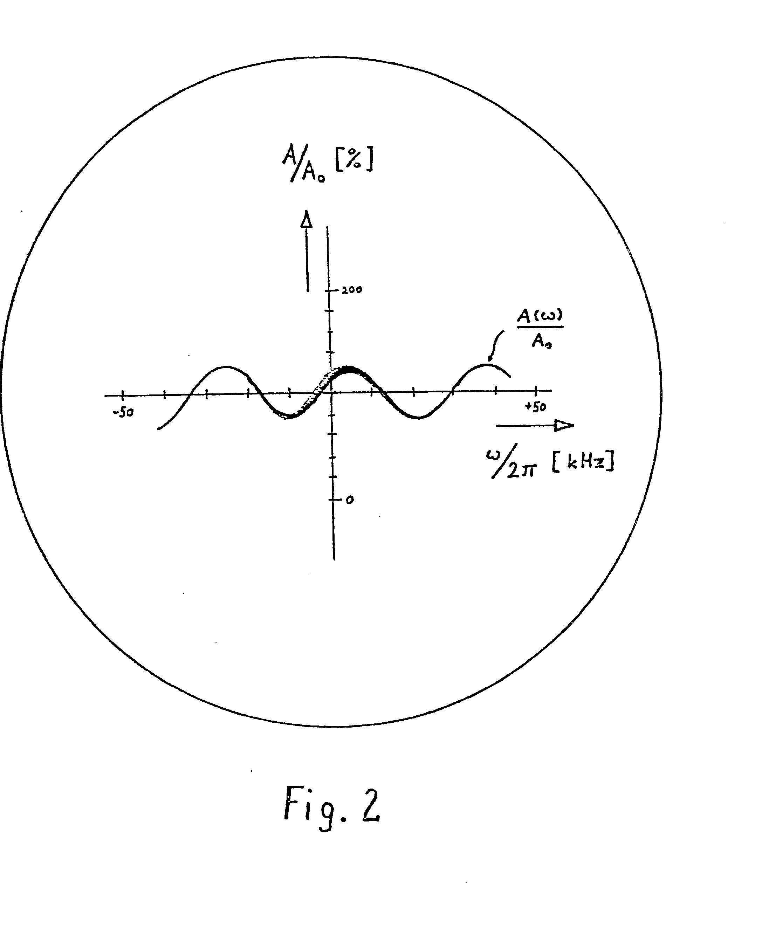

Durch die Konstantregelung des ZF-Trägers und geeignete Wahl
des Regler-Sollwertes am Potentiometer 110 wird erreicht, daß
die der Trägeramplitude entsprechende Bezugsachse der wiedergegebenen Kurve $\frac{A(\omega)}{A_0}$ während des gesamten Meßvorganges in Deckungsgleichheit mit der Skalenabszisse eines auf dem Oszillographenschirm
aufgetragenen Skalenkreuzes gehalten wird (Fig. 2). Damit läßt
sich die wiedergegebene Kurve $\frac{A(\omega)}{A_0}$ ohne Schwierigkeit anhand des
Skalenkreuzes genau vermessen, wobei der Maßgenauigkeit ferner
förderlich ist, daß die den X-, Y-Ablenkeinrichtungen des
Oszillographen 150 vorgeschalteten Tiefpässe 130 bzw. 140 ein
rauscharmes Oszillogramm gewährleisten und dennoch durch die
geeignete Wahl der Bandbreiten die Eindeutigkeit der Kurve
nicht verloren geht.

In Fig. 2 ist eine Ansicht des Oszillographenschirmes dargestellt, wobei auf dem Schirm ein Skalenkreuz aufgetragen ist, deren Abszissenskala in Frequenzeinheiten und deren Ordinatenskala in Verhältniseinheiten zwischen der Amplitude des UKW-Signals und der Amplitude des Signales ohne Reflexionen geeicht ist. Die im dargestellten Beispielsfall eingezeichnete sinusförmige Kurve $\frac{A(\omega)}{A_0}$ stellt einen vereinfachten Spezialfall einer Amplituden-Störmodulation dar, da in der Praxis wesentlich kompliziertere Formen der oszillographierten Kurve auftreten. Wesentlich ist, daß die Bezugsachse der Kurve $\frac{A(\omega)}{A_0}$ während des gesamten Meßverlaufes mit der Abszissenskala zusammenfällt, und zwar auch dann, wenn die Empfangsverhältnisse, beispielsweise durch Verdrehen der Empfangsantenne 11 (Fig. 1), verändert werden. Hierdurch kann die dargestellte Kurve $\frac{A(\omega)}{A_0}$ von einer Bedienungsperson problemlos und fortlaufend ausgemessen werden, wobei im Falle einer Veränderung der Empfangsverhältnisse das Optimum leicht feststellbar ist. Die Ausmessung der wiedergegebenen Kurve $\frac{A(\omega)}{A_0}$ kann auf verschiedene Weise erfolgen, vorzugsweise durch Feststellung des maximalen Kurvengradienten, wie in der prioritätsgleichen Anmeldung P .......... (Reg. 575) näher erläutert ist.

DIPL.-PHYS. TH. BOSSERT
WIEDENMAYERSTRABE 2
8000 MÜNCHEN 22

PATENTANSPRÜCHE

1. Verfahren zum Messen der Empfangsqualität eines frequenzmodulierten UKW-Signals, bei dem die durch Wellenreflexionen modulierte Amplitude und die Frequenz des UKW-Signals getrennt ermittelt und in Relation zueinander gesetzt werden, d a d u r c h   g e k e n n z e i c h n e t , daß die Amplitude des UKW-Signalträgers auf einen konstanten Wert geregelt wird, derart, daß die dem UKW-Signalträger aufmodulierte Störamplitude ungeregelt bleibt.

2. Verfahren nach Anspruch 1, d a d u r c h   g e k e n n - z e i c h n e t ,   daß der momentane Frequenzhub "Null" des UKW-Signals erfaßt und in Abhängigkeit von dieser Nullerfassung eine Verstärkungsregelung für einen Signalzweig zur Ermittlung der UKW-Signalamplitude getastet wird.

3. Einrichtung zum Messen der Empfangsqualität eines frequenzmodulierten UKW-Signals, insbesondere nach dem Verfahren gemäß Anspruch 1 oder 2, mit einer Kettenanordnung aus einem eingangsseitigen UKW-Tuner, einem Bandpaß und einer Signalverzweigung, welche letztere einen ersten Signalzweig mit einem

0010109

FM-Zwischenfrequenzverstärker und einem begrenzenden
FM-Diskriminator sowie einen zweiten Signalzweig mit einem
regelbaren AM-Zwischenfrequenzverstärker und einem AM-Demodulator aufweist, g e k e n n z e i c h n e t   d u r c h
eine Regelschleife (70, 80, 81, 100, 101) für den
AM-Zwischenfrequenzverstärker (70), welche von einem
Detektor (90) für den momentanen Frequenzhub "Null" des
UKW-Signals tastbar ist.

4. Einrichtung nach Anspruch 3,   d a d u r c h   g e k e n n -
   z e i c h n e t ,   daß der Detektor (90) eingangsseitig
   mit dem Ausgang des FM-Diskriminators (40) verbunden ist
   und daß die Regelschleife (70, 80, 81, 100, 101) einen von
   dem Detektor (90) getasteten Regler (100) aufweist, dessen
   Istwerteingang mit dem Ausgang des AM-Demodulators (80)
   verbunden ist.

5. Einrichtung nach Anspruch 4,   d a d u r c h   g e k e n n -
   z e i c h n e t ,   daß als Detektor (90) ein Fensterdiskriminator vorgesehen ist.

6. Einrichtung nach einem der Ansprüche 2 bis 5,   d a d u r c h
   g e k e n n z e i c h n e t ,   daß die beiden Signalzweige
   (50, 60) über jeweils ein bandbreitenvariables Tiefpaßfilter
   (130 bzw. 140) mit X- bzw. Y-Ablenkeinrichtungen eines
   Kathodenstrahloszillographen (150) verbunden sind.

Fi g.1

0010109

Fig. 2

**Europäisches Patentamt**

**EUROPÄISCHER RECHERCHENBERICHT**

Nummer der Anmeldung

**EP 78 10 1221**

| | EINSCHLÄGIGE DOKUMENTE | | | KLASSIFIKATION DER ANMELDUNG (Int.Cl.²) |
|---|---|---|---|---|
| Kategorie | Kennzeichnung des Dokuments mit Angabe, soweit erforderlich, der maßgeblichen Teile | betrifft Anspruch | | H 04 B 17/00<br>H 03 J 3/14<br>H 04 B 1/16 |
| | <u>US - A - 3 525 045</u> (RECKLINGHAUSEN)<br>   * Spalte 4, Zeilen 1-3, 40-75;<br>    Spalte 5, Zeilen 1-55 * | 1-3 | | |
| | -- | | | |
| | FUNKSCHAU, Vol. 48, November 1976,<br>Heft 24<br>München, D.<br>R. WIESHOFF: "FM 2002 ein Hi-Fi-<br>Tuner der Weltspitzenklasse", Sei-<br>ten 1067-1072<br>   * Seite 1070, erste Spalte, Zei-<br>    le 10 - zweite Spalte, Zeile<br>    9 * | 1 | | |
| | -- | | | RECHERCHIERTE SACHGEBIETE (Int. Cl.²) |
| | FUNKSCHAU, Vol. 43, September 1971<br>Heft 17<br>München, D.<br>W. OPPERMANN: "UKW-Stereo-Tuner<br>mit eingebautem Oszillografen",<br>Seiten 549 und 550<br>   * Seite 549, Mittelspalte, Zeile<br>    4 - Seite 550, rechte Spalte,<br>    Zeile 4 * | 1,3,6 | | H 04 B 17/00<br>H 03 J 3/14<br>G 01 R 23/08<br>        29/06<br>H 04 B 1/00<br>        1/16<br>        7/00 |
| | -- | | | |
| | AUDIO, Vol. 53, Nr. 3, März 1969<br>New York, U.S.A.<br>L. FELDMAN: "ABZs of FM", Seiten<br>40,42,74<br>   * Seite 42, linke Spalte, letzter<br>    Absatz - Seite 74, rechte<br>    Spalte, letzte Zeile * | 1-3,6 | | KATEGORIE DER GENANNTEN DOKUMENTE |
| | -- | | | X: von besonderer Bedeutung<br>A: technologischer Hintergrund<br>O: nichtschriftliche Offenbarung<br>P: Zwischenliteratur<br>T: der Erfindung zugrunde liegende Theorien oder Grundsätze<br>E: kollidierende Anmeldung<br>D: in der Anmeldung angeführtes Dokument<br>L: aus andern Gründen angeführtes Dokument |
| | FUNKSCHAU, Vol. 49, Oktober 1977<br>Heft 22<br>München, D.<br>P. RAHTGENS: "Oszilloskop als<br>                        ./. | 1-3,6 | | |

| | | | &: Mitglied der gleichen Patent-<br>familie, übereinstimmendes<br>Dokument |
|---|---|---|---|
| Der vorliegende Recherchenbericht wurde für alle Patentansprüche erstellt. | | | |

| Recherchenort | Abschlußdatum der Recherche | Prüfer |
|---|---|---|
| Den Haag | 15-06-1979 | GEISLER |

EPA form 1503.1 06.78

Europäisches
Patentamt

**EUROPÄISCHER RECHERCHENBERICHT**

0010109

Nummer der Anmeldung

**EP 78 10 1221**

-2-

| EINSCHLÄGIGE DOKUMENTE | | | KLASSIFIKATION DER ANMELDUNG (Int.Cl.²) |
|---|---|---|---|
| Kategorie | Kennzeichnung des Dokuments mit Angabe, soweit erforderlich, der maßgeblichen Teile | betrifft Anspruch | |
| | Funktionsanzeige in einem Quadro-Receiver", Seiten 1035-1038 | | |
| | * Seite 1035, rechte Spalte, Zeilen 9-15; Seite 1037, Mittelspalte, Zeile 17 - rechte Spalte, letzte Zeile * | | |
| | -- | | |
| | US - A - 3 869 673 (CLOSE) | 1,3 | |
| | * Figur 1 * | | |
| | -- | | RECHERCHIERTE SACHGEBIETE (Int. Cl.²) |
| A | NACHRICHTENTECHNISCHE ZEITSCHRIFT, 1966, Heft 3, Berlin, D. M. MUELLER: "Zum Problem der Messung von Uebertragungseigenschaften bei Systemen mit Kleinhub-FM", Seiten 147-155 | 1 | |
| | * Bild 5 * | | |
| | -- | | |
| A | DE - B - 1 952 739 (TRAUB) | 1 | |
| | * Spalte 2, Zeilen 55-65 * | | |
| | ---- | | |